# FASCICULE DE BREVET EUROPEEN

(11) **EP 2 461 278 B1**
(45) Date de publication et mention de la délivrance du brevet: **29.05.2013**
(21) Numéro de dépôt: 11191352.1
(22) Date de dépôt: 30.11.2011
(51) Int. Cl.: G06K 19/077

(54) **Procédé d'encartage d'un module dans une carte à microcircuit**
Einlegeverfahren eines Moduls in eine Mikrochipkarte
Method for inserting a module in a chip card

(30) Priorité: 06.12.2010 FR 1060112
(43) Date de publication de la demande: 06.06.2012
(73) Titulaire: Oberthur Technologies, 92300 Levallois-Perret (FR)
(72) Inventeur: Bosquet, Olivier, 92000 Nanterre (FR); Laknin, Mourad, 92000 Nanterre (FR); Vere, Denis, 92000 Nanterre (FR)
(74) Mandataire: Delumeau, François Guy

(56) Documents cités:
- EP-A1- 0 197 847
- EP-A2- 2 133 828
- WO-A1-2010/112761

## Description

La présente invention concerne le domaine technique des cartes à microcircuit, désignées également couramment par cartes à puce.

Elle s'applique plus particulièrement mais non spécifiquement au domaine des cartes à puce dites « dual interface » car comportant deux interfaces : une première interface utilisant des contacts électriques externes pour établir une communication dite « avec contact » et une deuxième interface utilisant une antenne magnétique de communication en champ proche, par exemple formée d'un enroulement d'une pluralité de spires électriquement conductrices, incorporée dans la carte, pour établir une communication dite «sans contact».

Généralement, le corps d'une carte à puce est réalisé en matière plastique. Le corps de carte est par exemple formé par un empilement de feuilles en matière plastique laminées entre elles. La pile de couches comprend notamment une couche centrale, désignée également par l'expression anglo-saxonne « inlay », qui a par exemple une fonction de support notamment de l'antenne.

Une fois le corps de carte laminé, une cavité est usinée dans le corps afin de former un logement pour le module à microcircuit. La cavité est délimitée par une surface interne présentant au moins une plage de contact avec le module pour la solidarisation du module dans la cavité lorsque ce dernier est encarté dans le corps. Le module est par exemple fixé à l'intérieur de la cavité notamment sur cette plage de contact par collage.

Il existe à ce jour un besoin constant d'apporter de nouvelles fonctionnalités à la carte. Il est ainsi connu d'ajouter des composants additionnels à la carte en plus de l'antenne et du module à microcircuit.

Par exemple, il est connu d'ajouter une diode électroluminescente raccordée électriquement à l'antenne et apte à indiquer par une fonction d'éclairage le bon déroulement d'une communication sans contact.

La diode électroluminescente est généralement formée par un composant monté à la surface de la couche « inlay » formant support. Généralement, ce type de composant est monté par brasage sur son support par apport d'une masse formant brasure, dit pâte à braser, puis par fusion de cette masse dans un four dit « four à refusions ». La refusion permet d'atteindre le point de fusion de la pâte à braser et de fixer ainsi le composant. La température de refusions est d'environ 200°C-230°C et dépend notamment de la nature de la pâte à braser.

Ainsi, la couche « inlay » doit être réalisée dans un matériau permettant de supporter les hautes températures des fours à refusions, notamment des températures supérieures à 200°C. Un matériau plastique convenant bien à cette application est par exemple le PET.

L'inconvénient d'un tel matériau est qu'il présente une plus faible adhérence à des matériaux adhésifs destinés à fixer le module que le PVC qui est le matériau classiquement utilisé pour la fabrication des autres couches du corps. Ceci pose un problème notamment lorsque la cavité est formée au moins partiellement à l'intérieur de cette couche « inlay » et que le module, lorsqu'il est rapporté à l'intérieur de la cavité, doit être fixé en partie à cette couche.

Ainsi, on observe, lors des tests de résistance de la carte en flexion ou en torsion, des décollements du module à partir de mille cycles appliqués. Ceci a pour effet qu'un nombre conséquent de cartes à microcircuit doivent être rejetées car présentant un défaut fonctionnel.

WO2010/112761 divulgue un insert formant antenne et une carte à puce incorporant l'insert. EP 2133828 divulgue un procédé d'insertion d'un module à microcircuit dans un corps de carte. EP 0197848 divulgue un procédé de fabrication de carte à mémoire électronique.

L'invention a notamment pour but de proposer une carte à microcircuit permettant l'incorporation de composants additionnels avec une fiabilité et une résistance accrues.

A cet effet, l'invention a pour objet une carte à microcircuit comprenant un module à microcircuit et un corps comprenant une cavité d'encartage du module, dans laquelle la cavité délimite en surface au moins une plage de fixation du module dans la cavité, le corps étant formé par une pile d'au moins des première et deuxième couches dites respectivement de faible adhérence et de forte adhérence avec le module, caractérisée en ce que la plage s'étend dans la couche de faible adhérence et comprend au moins un trou débouchant dans la couche de forte adhérence pour former un point d'ancrage du module avec cette couche.

Selon un mode de réalisation préféré de l'invention, la couche de faible adhérence est un inlay formant support d'au moins un composant électronique.

De préférence, le composant électronique est un composant monté en surface sur la couche de faible adhérence. Dans un mode de réalisation préféré, le composant est assemblé sur son support par une technique de soudure par refusions.

Dans un mode de réalisation préféré, la couche de faible adhérence porte une antenne de communication à champ proche.

De préférence, la cavité comprenant un fond et une paroi périphérique munie d'un gradin formant un rebord d'appui, la plage s'étend sur ce rebord d'appui. Dans ce cas, le trou débouche dans la couche de forte adhérence et traverse la couche de faible adhérence. Le module est alors rapporté par exemple par collage directement à la couche de forte adhérence soit par apport d'une masse adhésive apte à s'écouler dans le trou soit par fluage du matériau de la couche de forte adhérence à l'intérieur du trou pour atteindre la surface de la plage de fixation.

Dans un mode de réalisation préféré, le fond de la cavité s'étend dans la couche de forte adhérence. Ceci permet d'augmenter avantageusement la surface de collage du module avec la couche de forte adhérence. Le module est raccordé d'une part à la plage de fixation qui s'étend dans la couche de faible adhérence et d'autre part au fond de la cavité qui s'étend directement à l'intérieur de la couche de forte adhérence.

Dans un mode de réalisation préféré, la couche d'inlay est réalisée essentiellement dans un matériau ayant une haute température de fusion. Ceci lui permet de supporter les hautes températures par exemple des fours à refusions.

Une carte selon l'invention peut en outre comporter l'une ou plusieurs des caractéristiques suivantes :
- le corps comprend au moins deux couches de forte adhérence entre lesquelles est intercalée la couche de faible adhérence ;
- le module est rapporté par collage sur la plage de fixation.

L'invention a encore pour objet un procédé de fabrication d'une carte selon l'invention, dans lequel on forme la carte par lamination d'au moins les deux couches, **caractérisé en ce que,** avant lamination, on forme au moins un trou traversant la couche de faible adhérence dans un emplacement délimitant la plage et, pendant la lamination, on laisse fluer la matière de la couche de forte adhérence à travers le trou.

L'invention a enfin pour objet un procédé de fabrication d'une carte selon l'invention, dans lequel on forme la carte par lamination d'au moins les deux couches, **caractérisé en ce que** l'on forme la cavité dans le corps et l'on forme le trou au niveau de la plage une fois la cavité formée.

D'autres caractéristiques et avantages de l'invention apparaîtront à la lumière de la description qui suit, faite en référence aux dessins annexés dans lesquels :
- la figure 1 représente une carte à microcircuit selon un premier mode de réalisation de l'invention ;
- la figure 2 représente une vue en coupe de la carte selon la ligne II-II de la figure 1 ;
- la figure 3 est une vue agrandie de la partie cerclée III de la figure 2 ;
- la figure 4 représente une carte à microcircuit selon un deuxième mode de réalisation de l'invention ;
- les figures 5 à 7 illustrent des étapes de fabrication de la carte de la figure 1 ;
- les figures 8 à 11 illustrent les étapes de fabrication principales de la carte de la figure 4.

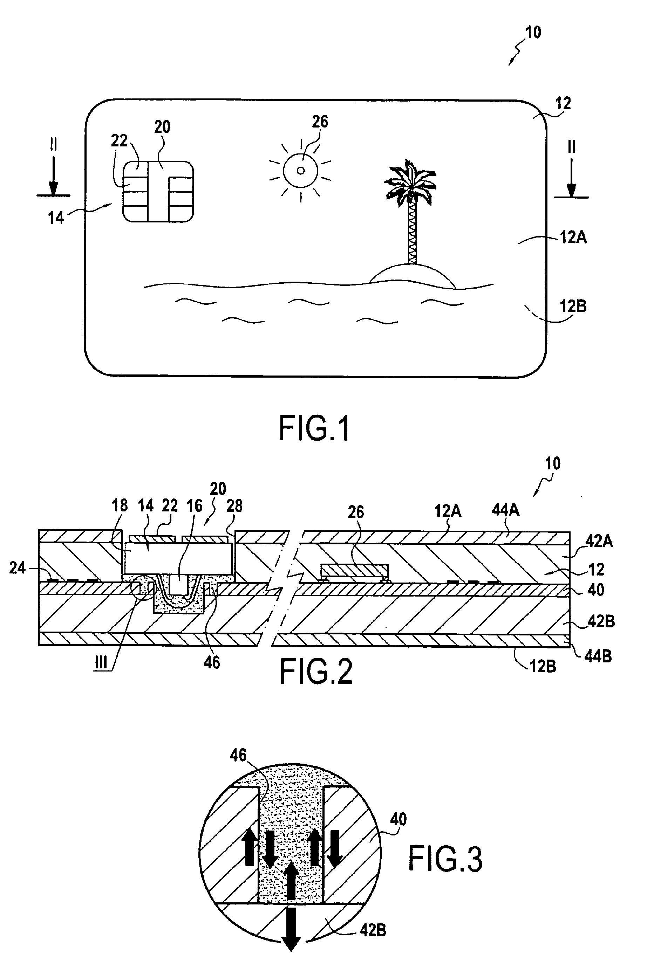

On a représenté sur **la** **figure 1** une carte à microcircuit. Cette carte à microcircuit est désignée par la référence générale 10.

La carte 10 comprend généralement un corps 12 délimitant les dimensions extérieures de la carte 10. Le corps 12 délimite des faces opposées 12A et 12B. Le corps 12 délimite les dimensions extérieures de la carte 10, conformes au format défini par la norme ISO 7816 des cartes à microcircuit.

Le corps 12 est par exemple réalisé dans un matériau comprenant essentiellement du plastique. De préférence, le corps 12 est formé par lamination d'une pile de couches.

La carte 10 incorpore en outre un module 14 à microcircuit 16.

De préférence, le module 14 comprend un support 18 délimitant des première 18A et deuxième 18B faces opposées, l'une des faces 18A portant le microcircuit 16 et l'autre des faces 18B portant une interface 20 de contacts externes 22 destinée à s'étendre sur l'une des faces de la carte 10, par exemple la face 12A illustrée sur **la** **figure 1****.**

Le support 18 est, par exemple, réalisé dans un matériau comprenant essentiellement de l'époxy et a, par exemple, une épaisseur inférieure à 200 µm et de préférence comprise entre 70 et 100 µm.

De préférence, le microcircuit 14 peut être monté sur le support 18 du module 14 par un procédé de câblage appelé conformément à la terminologie anglo-saxonne « Wire Bonding » qui consiste à coller le microcircuit 16 sur le support 18 par sa face passive et à câbler le microcircuit 16 à partir de sa face active pour son raccordement électrique. Dans ce cas, le microcircuit 16 et les câbles sont par exemple encapsulés, comme cela est illustré sur **la** **figure 2****,** dans une calotte de résine polymère.

Dans une variante non illustrée sur les figures, le microcircuit 16 peut être assemblé par report de puce et est, dans ce cas, dit monté-retourné dans le module à microcircuit 16. Ce procédé d'assemblage est désigné couramment dans la terminologie anglo-saxonne par montage "flip-chip". Ce procédé d'assemblage se caractérise par une connexion électrique directe de la face active du microcircuit 16 sur le support 18 pour le raccordement électrique avec des conducteurs appropriés sur le support 18.

Dans l'exemple décrit, la carte 10 est de type duale, c'est-à-dire qu'elle permet l'établissement, en plus d'une communication de type à contact au moyen de l'interface 20 de contacts externes 22, d'une communication de type sans contact par champ proche.

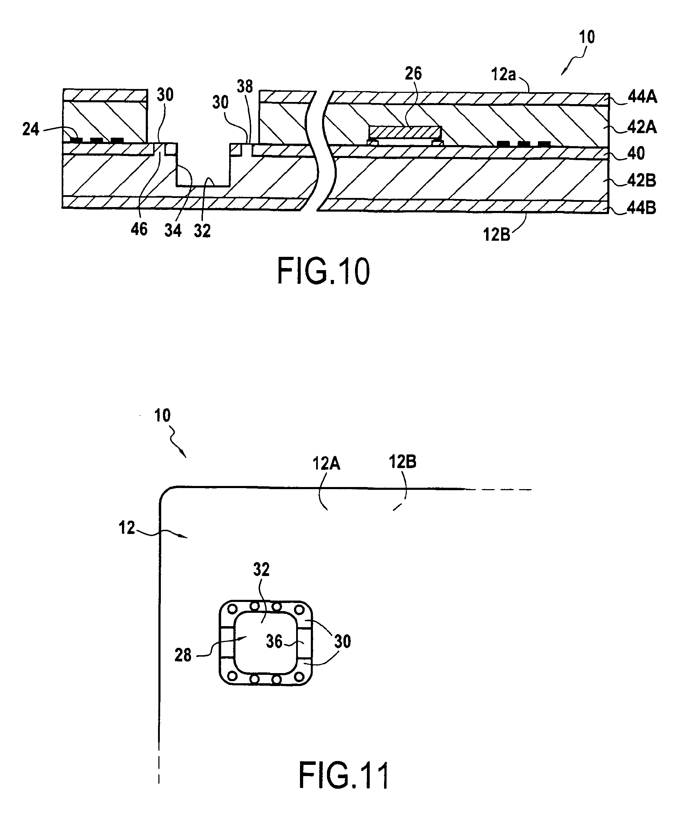

A cet effet, afin de permettre la transmission d'informations en champ proche, la carte 10 comprend en outre une antenne 24 incorporée dans le support 18. L'antenne 24 est par exemple formée par un enroulement de spires s'étendant le long de la périphérie du corps 12 de la carte 10. L'antenne 24 est également par exemple munie d'au moins deux extrémités raccordées électriquement au microcircuit 16. Par exemple, pour raccorder électriquement l'antenne 24 et le microcircuit 16, le corps 12 incorpore des pastilles métalliques 36, disposées à chacune des extrémités de l'antenne 24 aptes à établir un pont électrique entre des broches du microcircuit 16 et des extrémités de l'antenne 24 (de telles pastilles sont par exemple illustrées sur **la** **figure 11****).**

En outre, dans ce deuxième mode de réalisation, la carte 10 comprend au moins un composant électronique 26 de type monté en surface (acronyme français « CMS »). Dans cet exemple, le composant électronique 26 est une diode électroluminescente.

La diode électroluminescente 26 est par exemple alimentée via l'antenne 24 qui est incorporée dans l'épaisseur du corps 12. Ainsi, la diode 26 forme un voyant lumineux apte à s'allumer lorsqu'une communication en champ proche s'établit. Ceci permet par exemple d'informer l'utilisateur de la carte du bon déroulement de la communication ou au contraire de son échec. La diode 26 est par exemple, comme cela est illustré sur **la** **figure 1****,** insérée dans un décor imprimé sur la carte 10, par exemple au centre d'un motif représentant un soleil.

Conformément à l'invention, le corps 12 comprend une cavité 28 d'encartage du module 14, qui délimite en surface au moins une plage 30 de fixation du module 14 dans la cavité 28. De préférence, la cavité 28 est dimensionnée pour recevoir entièrement le module 14.

Dans cet exemple, la cavité 28 comprend un fond 32 et une paroi périphérique 34 entourant le fond 32. Cette paroi périphérique 34 présente par ailleurs un gradin délimitant un rebord interne 38 d'appui du support 18 du module 14. La plage de fixation 30 s'étend dans l'exemple décrit sur le rebord d'appui 38.

Conformément à l'invention, le corps 12 est formé par au moins une pile de deux couches, une première couche de faible adhérence 40 avec le module 14 et une deuxième couche de forte adhérence 42 (42 A ou 42 B) avec le module 14. Par faible adhérence et forte adhérence, au sens de l'invention, on entend que le matériau constituant la couche de faible adhérence présente une énergie de surface plus faible que la couche de forte adhérence. Ainsi, avec une même masse adhésive, le module 14 présente une meilleure adhésion avec la couche de forte adhérence 42 qu'avec la couche de faible adhérence 40, par exemple lorsqu'il est rapporté par collage.

Dans ce mode de réalisation, la couche de faible adhérence 40 est une couche formant support du composant monté en surface 26. De façon connue en soi, le composant monté en surface 26 est fixé à un support 40 par une technique de soudure à refusions. Cette technique présente l'avantage de permettre la fixation d'un grand nombre de composants en une seule opération. Cette technique est généralement indispensable pour permettre le soudage de composants dont les broches sont trop petites ou inaccessibles pour être soudées au moyen d'un fer à souder classique.

Selon cette technique, le composant 26 est rapporté sur le support 40 avec une masse formant brasure, dite couramment pâte à braser, dont la température de fusion est supérieure généralement à 200°C. L'ensemble est chauffé à cette température de façon progressive, et ce afin d'éviter des chocs thermiques du composant 26, et est maintenu à une température de refusions pendant une durée déterminée. A l'issue de cette étape de chauffage, l'ensemble est refroidi.

De préférence, la couche « inlay » 40 est adaptée pour supporter des températures de refusions supérieures ou égales à 200°C. Par exemple, le matériau comprend essentiellement une matière plastique à base de PET. Ce matériau présente de faibles propriétés d'adhérence ce qui rend difficile le collage du module directement sur la face de la couche « d'inlay » 40.

Par ailleurs, de préférence, la couche de faible adhérence porte l'antenne 24. Par exemple, l'antenne 24 est déposée en surface de la couche de faible adhérence.

Dans l'exemple illustré sur **la** **figure 2****,** le corps 12 comprend une pile d'au moins cinq couches, la couche centrale formant « inlay » 40 étant intercalée entre deux couches supérieure 42A et inférieure 42B de compensation, l'ensemble étant également encore intercalé entre deux couches de protection transparentes 44A, 44B, dites «overlay ».

Comme cela est illustré sur **la** **figure 2****,** la plage de fixation 30 s'étend au moins partiellement dans la couche de faible adhérence 40. Ainsi, la plage de fixation 30 s'étend sur le rebord d'appui 38. En outre, de préférence, le fond de la cavité s'étend dans la couche de forte adhérence.

Conformément à l'invention, cette plage 30 comprend au moins un trou 46 débouchant dans la couche de forte adhérence pour former un point d'ancrage du module 16 avec cette couche de forte adhérence 42B.

Dans ce mode de réalisation, la plage de fixation 30 du module 16 comprend une pluralité de trous 46, par exemple au nombre de quatre, répartis de façon régulière sur le rebord d'appui 38. Sur **la** **figure 2****,** seulement deux trous 46 ont été représentés.

Le module 16 est de préférence rapporté par collage sur la plage de fixation 30. Dans ce premier mode de réalisation, la pluralité de trous 46 est formée après la formation de la cavité à l'intérieur de la couche de faible adhérence 40. Une masse adhésive est déposée entre le module 16 et la plage de fixation 30 et s'écoule à l'intérieur de chacun des trous 46.

Ainsi, comme cela est illustré en détail sur **la** **figure 3****,** la masse adhésive emplit le volume creux du trou débouchant 46. La présence du trou 46 présente l'avantage d'augmenter la surface de contact totale pour obtenir une meilleure adhérence du module à la carte. En outre, la masse adhésive produit des efforts de cisaillement au niveau des parois verticales des trous lorsque la carte est soumise à des flexions et des torsions (les efforts sont représentés schématiquement par les flèches de **la** **figure 3****).** Généralement, les adhésifs sont plus résistants aux efforts de cisaillement qu'aux efforts de traction. De plus, l'augmentation de la surface de collage liée à la présence des trous permet de diminuer la valeur des efforts exercés par unité de surface.

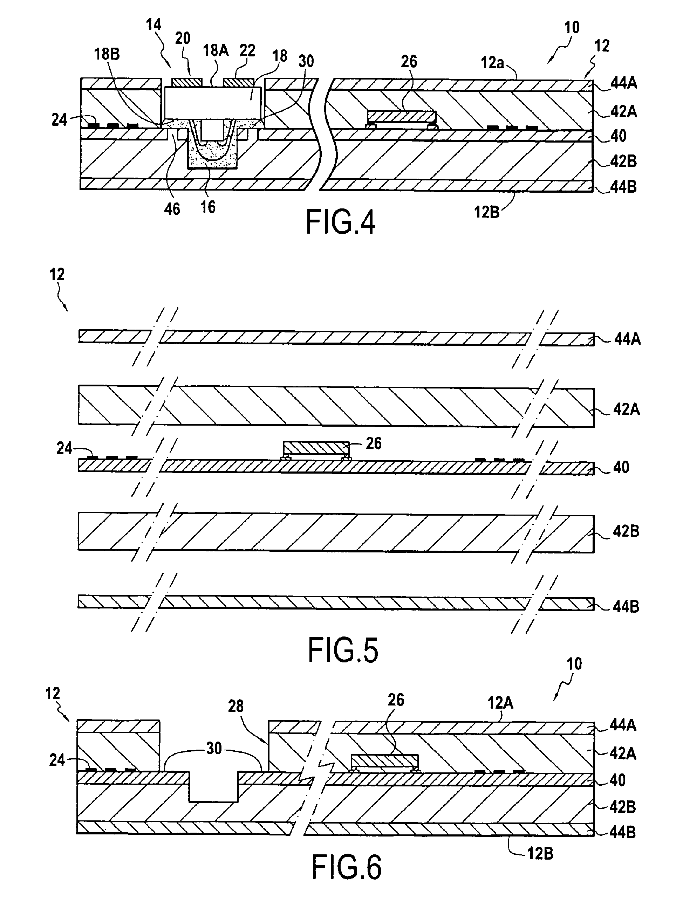

On a représenté sur **la** **figure 4** une vue en coupe d'une carte selon un deuxième mode de réalisation de l'invention. Sur cette **figure 4****,** les éléments analogues à ceux des figures précédentes sont désignés par des références identiques.

A la différence du premier mode de réalisation, dans ce deuxième mode de réalisation, le ou les trous 46 sont remplis du matériau constituant la couche de forte adhérence 42. Par exemple, les trous 46 sont formés avant lamination du corps de carte et sont remplis par fluage à l'intérieur des trous 46 du matériau constituant la couche de forte adhérence 42.

Ainsi, de préférence, le ou les trous 46 sont remplis par le matériau de la couche de forte adhérence 46 et ce matériau 46 affleure à la surface de la plage de fixation 30. Ceci présente l'avantage de fixer directement le module 14 au matériau de la couche de forte adhérence 42.

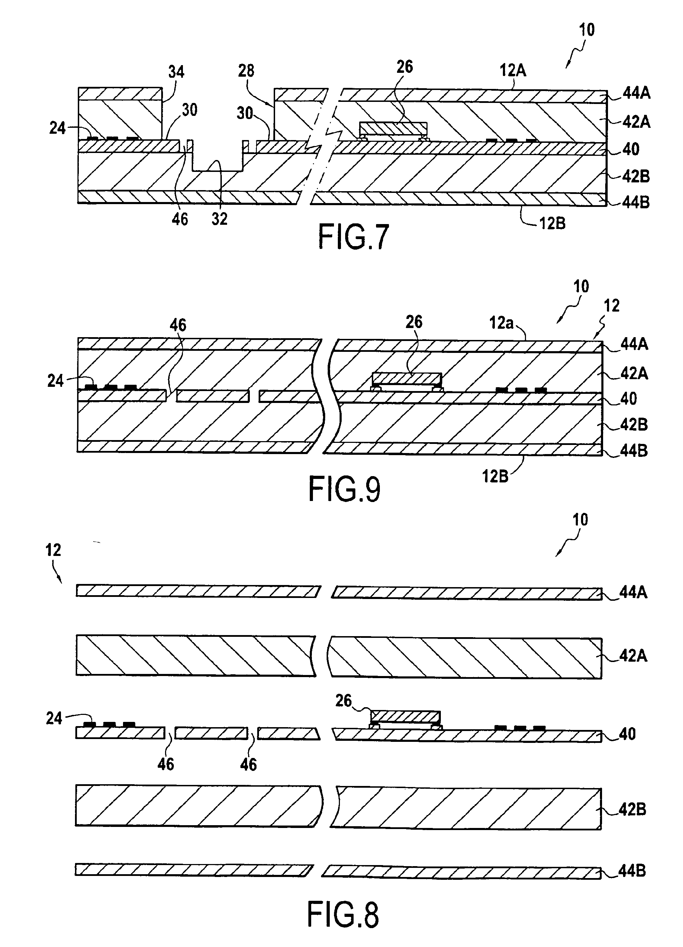

On va maintenant décrire les principales étapes d'un procédé de fabrication d'une carte à microcircuit selon le premier mode de réalisation en référence **aux** **figures 5 à 7** et d'une carte à microcircuit selon le deuxième mode de réalisation en référence **aux** **figures 8 à 10****.**

Au cours d'une première étape illustrée sur **la** **figure 5****,** on empile les cinq couches formant le corps de la carte 12 : la couche « inlay » 40 est ainsi intercalée entre deux couches de compensation 42A, 42B, elles-mêmes intercalées entre deux couches transparentes dites « overlay » 44A, 44B. La couche « inlay » 40 forme un support pour divers composants montés en surface dont la diode électroluminescente 26 et porte sur une de ses faces une antenne imprimée 24 et un jeu de pastilles électriquement conductrices pour le raccordement électrique de l'antenne 24 et du module 14. L'antenne 24 est formée par exemple par photogravure d'une couche de cuivre. La pile de couches est ensuite par exemple laminée pour former le corps de carte 12.

Au cours d'une deuxième étape illustrée sur **la** **figure 6****,** on forme une cavité 28 dans le corps laminé 12.

Dans l'exemple décrit, une telle cavité 28 est généralement obtenue par exemple par usinage, typiquement par fraisage ou lamage en deux opérations :
- un grand lamage pour former la zone périphérique correspondant à la profondeur du gradin,
- un petit lamage pour former la zone centrale plus profonde.

Au cours de la formation du grand lamage, les pastilles électriquement conductrices sont partiellement mises à nues ce qui permet leur raccordement électrique ultérieur avec le module 14 et à l'antenne.

Ensuite, on forme les trous d'ancrage 46 du module 14 dans le corps 12. Ces trous 46 sont par exemple formés à côté des pastilles électriquement conductrices 36. La cavité 28 est alors remplie d'une masse adhésive pouvant s'écouler notamment à l'intérieur des trous 46.

Dans le second mode de réalisation de la carte dont les principales étapes du procédé sont illustrées sur **les** **figures 8 à 11****.**

Dans ce second mode de réalisation, avant lamination, on forme au moins un trou 46 traversant la couche de faible adhérence 40 dans un emplacement délimitant la plage 30 **(****figure 8****).**

En outre, pendant l'étape de lamination, on laisse fluer la matière de la couche de forte adhérence 42B à travers chaque trou 46 **(****figure 9****).**

Puis, au cours d'une troisième étape illustrée sur **la** **figure 10****,** on forme la cavité. Lors de l'usinage de la cavité 28, les pastilles électriquement conductrices 36 sont mises à nues ainsi que les trous 46 emplis de cette couche de forte adhérence. Comme cela est illustré sur **la** **figure 11****,** la plage de fixation 30 du module 14 à la carte 10 comprend au moins six trous d'ancrage 46.

Il est bien entendu que les modes de réalisation qui viennent d'être décrits ne présentent aucun caractère limitatif et qu'ils pourront recevoir toute modification désirable sans sortir pour cela du cadre de l'invention.

## Revendications

1. Carte à microcircuit (10) comprenant un module (14) à microcircuit (16) et un corps (12) comprenant une cavité (28) d'encartage du module (14), dans laquelle la cavité (28) délimite en surface au moins une plage (30) de fixation du module (14) dans la cavité (28), le corps (12) étant formé par une pile d'au moins des première (40) et deuxième (42A, 42B) couches dites respectivement de faible adhérence et de forte adhérence avec le module (14), **caractérisée en ce que** la plage (30) s'étend dans la couche de faible adhérence (40) et comprend au moins un trou (46) débouchant dans la couche de forte adhérence (42A, 42B) pour former un point d'ancrage du module (14) directement avec cette couche de forte adhérence (42A, 42B).

2. Carte (10) selon la revendication précédente, dans laquelle la couche de faible adhérence (40) est un inlay formant support d'au moins un composant électronique (26).

3. Carte (10) selon la revendication précédente, dans laquelle le composant électronique (26) est un composant monté en surface.

4. Carte (10) selon l'une quelconque des revendications précédentes, dans laquelle la couche de faible adhérence (40) porte une antenne de communication à champ proche (24).

5. Carte (10) selon l'une quelconque des revendications précédentes, dans laquelle le corps (12) comprend au moins deux couches de forte adhérence (42A, 42B) entre lesquelles est intercalée la couche de faible adhérence (40).

6. Carte (10) selon l'une quelconque des revendications précédentes, dans laquelle, la cavité (28) comprenant un fond (32) et une paroi périphérique (34) munie d'un gradin formant un rebord d'appui, la plage (30) s'étend sur ce rebord d'appui.

7. Carte (10) selon la revendication précédente, dans laquelle le fond (32) de la cavité (28) s'étend dans la couche de forte adhérence (42A, 42B).

8. Carte (10) selon l'une quelconque des revendications précédentes, dans laquelle la couche d'inlay (40) est réalisée essentiellement dans un matériau ayant une haute température de fusion.

9. Carte (10) selon l'une quelconque des revendications précédentes, dans laquelle le module (14) est rapporté par collage sur la plage (30).

10. Procédé de fabrication d'une carte (10) selon l'une quelconque des revendications précédentes, dans lequel on forme la carte (10) par lamination d'au moins les deux couches (40, 42A, 42B), **caractérisé en ce que**, avant lamination, on forme au moins un trou (46) traversant la couche de faible adhérence (40) dans un emplacement délimitant la plage (30) et, pendant la lamination, on laisse fluer la matière de la couche de forte adhérence (42A, 42B) à travers le trou (46).

11. Procédé de fabrication d'une carte (10) selon l'une quelconque des revendications 1 à 9, dans lequel on forme la carte (10) par lamination d'au moins les deux couches (40, 42A, 42B), **caractérisé en ce que** l'on forme la cavité (28) dans le corps (12) et l'on forme le trou (46) au niveau de la plage (30) une fois la cavité (28) formée.

## Patentansprüche

1. Mikrochipkarte (10), umfassend ein Modul (14) mit Mikroschaltkreis (16) und einen Körper (12) mit einer Vertiefung (28) zum Einlegen des Moduls (14), wobei die Vertiefung (28) an der Oberfläche wenigstens einen Bereich (30) zum Befestigen des Moduls (14) in der Vertiefung (28) begrenzt, wobei der Körper (12) durch einen Stapel aus wenigstens einer ersten Schicht (40) und einer zweiten Schicht (42A, 42B) mit geringer Haftung bzw. mit starker Haftung mit dem Modul (14) gebildet ist, **dadurch gekennzeichnet, daß** der Bereich (30) sich in der Schicht mit geringer Haftung (40) erstreckt und wenigstens ein in die Schicht mit starker Haftung (42A, 42B) mündendes Loch (46) umfaßt, um eine Stelle zur Verankerung des Moduls (14) direkt mit dieser Schicht mit starker Haftung (42A, 42B) zu bilden.

2. Karte (10) nach dem vorhergehenden Anspruch, wobei die Schicht mit geringer Haftung (40) ein Inlay ist, das einen Halter wenigstens eines elektronischen Bauteils (26) bildet.

3. Karte (10) nach dem vorhergehenden Anspruch, wobei das elektronische Bauteil (26) ein oberflächenmontiertes Bauteil ist.

4. Karte (10) nach einem der vorhergehenden Ansprüche, wobei die Schicht mit geringer Haftung (40) eine Nahfeldkommunikationsantenne (24) trägt.

5. Karte (10) nach einem der vorhergehenden Ansprüche, wobei der Körper (12) wenigstens zwei Schichten mit starker Haftung (42A, 42B) umfaßt, zwischen denen die Schicht mit geringer Haftung (40) eingefügt ist.

6. Karte (10) nach einem der vorhergehenden Ansprüche, wobei, wenn die Vertiefung (28) einen Boden (32) und eine Umfangswand (34), welche mit einer einen Anlagerand bildenden Stufe versehen ist, umfaßt, der Bereich (30) sich über diesen Anlagerand erstreckt.

7. Karte (10) nach dem vorhergehenden Anspruch, wobei der Boden (32) der Vertiefung (28) sich in der Schicht mit starker Haftung (42A, 42B) erstreckt.

8. Karte (10) nach einem der vorhergehenden Ansprüche, wobei die Inlayschicht (40) im wesentlichen aus einem Material mit einer hohen Schmelztemperatur gefertigt ist.

9. Karte (10) nach einem der vorhergehenden Ansprüche, wobei das Modul (14) durch Kleben auf den Bereich (30) aufgesetzt ist.

10. Verfahren zur Herstellung einer Karte (10) nach einem der vorhergehenden Ansprüche, wobei die Karte (10) durch Kaschieren wenigstens der beiden Schichten (40, 42A, 42B) gebildet wird, **dadurch gekennzeichnet, daß** vor dem Kaschieren wenigstens ein die Schicht mit geringer Haftung (40) durchquerendes Loch (46) an einer den Bereich (30) begrenzenden Stelle ausgebildet wird und man während des Kaschierens das Material der Schicht mit starker Haftung (42A, 42B) durch das Loch (46) fließen läßt.

11. Verfahren zur Herstellung einer Karte (10) nach einem der Ansprüche 1 bis 9, wobei die Karte (10) durch Kaschieren wenigstens der beiden Schichten (40, 42A, 42B) gebildet wird, **dadurch gekennzeichnet, daß** die Vertiefung (28) in dem Körper (12) ausgebildet wird und, sobald die Vertiefung (28) ausgebildet ist, das Loch (46) im Bereich des Bereiches (30) ausgebildet wird.

## Claims

1. A smart card (10) comprising a module (14) having a microcircuit (16) and a body (12) including a cavity (28) for receiving the module (14), wherein the cavity (28) defines at least one surface area (30) for fastening the module (14) in the cavity (28), the body (12) being formed by a stack of at least first and second layers (40; 42A, 42B) respectively presenting weak adhesion and strong adhesion with the module (14), the card being **characterized in that** the area (30) extends in the weak adhesion layer (40) and includes at least one hole (46) leading to the strong adhesion layer (42A, 42B) so as to form an anchor point for the module (14) directly with said strong adhesion layer (42A, 42B).

2. A card (10) according to the preceding claim, wherein the weak adhesion layer (40) is an inlay forming a support for at least one electronic component (26).

3. A card (10) according to the preceding claim, wherein the electronic component (26) is a surface-mounted component.

4. A card (10) according to any preceding claim, wherein the weak adhesion layer (40) carries a near-field communications antenna (24).

5. A card (10) according to any preceding claim, wherein the body (12) includes at least two strong adhesion layers (42A, 42B) having the weak adhesion layer (40) interposed therebetween.

6. A card (10) according to any preceding claim, wherein the cavity (28) includes a bottom (32) and a peripheral wall (34) having a step forming a bearing rim, and the fastening area (30) extends over said bearing rim.

7. A card (10) according to the preceding claim, wherein the bottom (32) of the cavity (28) extends in the strong adhesion layer (42A, 42B).

8. A card (10) according to any preceding claim, wherein the inlay layer (40) is made essentially of a material having a high melting temperature.

9. A card (10) according to any preceding claim, wherein the module (14) is adhesively bonded on the fastening area (30).

10. A method of fabricating a card (10) according to any preceding claim, wherein the card (10) is formed by laminating together at least two layers (40, 42A, 42B), the method being **characterized in that** prior to lamination, at least one hole (46) is formed through the weak adhesion layer (40) in a location defining the fastening area (30), and during lamination, the material of the strong adhesion layer (42A, 42B) is allowed to creep through the hole (46).

11. A method of fabricating a card (10) according to any one of claims 1 to 9, wherein the card (10) is formed by laminating together at least two layers (40, 42A, 42B), the method being **characterized in that** the cavity (28) is formed in the body (12) and the hole (46) is formed in the fastening area (30) once the cavity (28) has been formed.
